Europäisches Patentamt

European Patent Office

Office européen des brevets

(19)

(11) **EP 1 016 219 B1**

(12) **EUROPÄISCHE PATENTSCHRIFT**

(45) Veröffentlichungstag und Bekanntmachung des Hinweises auf die Patenterteilung:
**26.03.2003  Patentblatt 2003/13**

(21) Anmeldenummer: **99930917.2**

(22) Anmeldetag: **16.07.1999**

(51) Int Cl.⁷: $H03L\ 7/113$, $H03L\ 7/16$

(86) Internationale Anmeldenummer:
**PCT/AT99/00179**

(87) Internationale Veröffentlichungsnummer:
**WO 00/004642 (27.01.2000 Gazette 2000/04)**

(54) **VERFAHREN UND EINRICHTUNG ZUM ERZEUGEN EINES AUSGANGSSIGNALS**

METHOD AND DEVICE FOR PRODUCING AN OUTPUT SIGNAL

PROCEDE ET DISPOSITIF POUR PRODUIRE UN SIGNAL DE SORTIE

(84) Benannte Vertragsstaaten:
**AT CH DE FR GB IT LI**

(30) Priorität: **16.07.1998  AT  122698**

(43) Veröffentlichungstag der Anmeldung:
**05.07.2000  Patentblatt 2000/27**

(73) Patentinhaber: **Contec Steuerungstechnik und Automation Ges.mbH**
**6330 Kufstein (AT)**

(72) Erfinder: **LEHNER, Thomas**
**A-6330 Kustein (AT)**

(74) Vertreter: **Torggler, Paul Norbert, Dr.**
**Patentanwälte**
**Torggler und Hofinger**
**Wilhelm-Greil-Strasse 16**
**Postfach 556**
**6021 Innsbruck (AT)**

(56) Entgegenhaltungen:
**WO-A-97/39529          NL-C- 1 002 594**
**US-A- 4 827 225**

• **FIOCCHI C ET AL: "A SIGMA-DELTA BASED PLL FOR NON-SINUSOIDAL WAVEFORMS" PROCEEDINGS OF THE INTERNATIONAL SYMPOSIUM ON CIRCUITS AND SYSTEMS, SAN DIEGO, MAY 10 - 13, 1992, Bd. 6, Nr. CONF. 25, 10. Mai 1992 (1992-05-10), Seiten 2661-2664, XP000338776 INSTITUTE OF ELECTRICAL AND ELECTRONICS ENGINEERS ISBN: 0-7803-0593-0**

**Beschreibung**

Die Erfindung betrifft ein Verfahren zum Erzeugen eines Ausgangssignals, dessen Ausgangsfrequenz sich um ein vorgebbares Übersetzungsverhältnis von der veränderbaren Eingangsfrequenz eines Eingangssignals unterscheidet, wobei die Phase des Ausgangssignals mit der Phase des Eingangssignals gekoppelt ist.

Ein mit der Phase eines Eingangssignals gekoppeltes Ausgangssignal wird herkömmlicherweise über eine PLL-Schaltung erzeugt, wie dies beispielsweise in "Halbleiter-Schaltungstechnik", U. Tietze und Ch. Schenk, Springer-Verlag Berlin, Heidelberg, 1980 beschrieben ist. Bei dieser ist ein Phasenregelkreis vorgesehen, bei dem die Frequenz des Ausgangssignals derart eingestellt wird, daß eine Phasendifferenz zwischen dem Eingangssignal und dem Ausgangssignal am Eingang des Phasenregelkreises verschwindet. Eine Änderung der Frequenz des Eingangssignals wird somit über Bauteile mit integrierendem Verhalten, die die Eingangsphase ermitteln, und den Phasenregelkreis in eine Änderung der Frequenz des Ausgangssignals umgesetzt, wodurch sich die Reaktionszeit stark verlangsamt (geringe Dynamik des Systems).

Die US-A-4,827,225 beschreibt ein System mit gleicher Eingangs- und Ausgangsfrequenz, bei der die Ausgangsfrequenz- und die Eingangsfrequenzphasen gekoppelt sind, wobei die Ausgangsfrequenz über einen analogen spannungsgesteuerten Oszillator (HCO) gebildet wird.

Die WO 97/39529 beschreibt eine Einrichtung und ein Verfahren zur Frequenzübersetzung, bei der die Ausgangsfrequenz mit einem bestimmten Übersetzungsverhältnis in Abhängigkeit von der Eingangsfrequenz geführt wird.

Aufgabe der Erfindung ist es, ein verbessertes Verfahren der eingangs genannten Art bereitzustellen, durch das u.a. eine höhere Genauigkeit und eine größere Dynamik ermöglicht wird.

Erfindungsgemäß gelingt dies beim Verfahren der eingangs genannten Art dadurch, daß die Eingangsfrequenz des Eingangssignals bezogen auf den Systemtakt eines Taktgebers ermittelt wird, ein der Ausgangsfrequenz entsprechender Wert als digitales Signal über das vorgegebene Übersetzungsverhältnis aus der Eingangsfrequenz berechnet wird, ein Ausgangssignal mit dieser Ausgangsfrequenz von einem digitalen Signalgenerator erzeugt wird, die Phase des Ausgangssignals entsprechend dem Zählwert des Ausgangszählers ermittelt wird, die Phase des Eingangssignals entsprechend dem Zählwert des Eingangszählers ermittelt wird, ein Phasenfehler der Phase des Ausgangssignals bezüglich der Phase des Eingangssignals bestimmt wird und zu vorgegebenen Zeitpunkten eine Korrektur der Phase des Ausgangssignals durchgeführt wird. Die erfindungsgemäße Einrichtung ist in Anspruch 13 gekennzeichnet.

Durch die unmittelbare Übersetzung der Eingangsfrequenz in die Ausgangsfrequenz wirkt sich eine Änderung der Eingangsfrequenz praktisch ohne Verzögerung auf die Ausgangsfrequenz aus.

Weiters wird im Gegensatz zu herkömmlichen PLLs die Kopplung der Phase des Ausgangssignals an die Phase des Eingangssignals auch bei großen Schwankungen der Eingangsfrequenz gewährleistet.

Weitere Vorteile und Einzelheiten der Erfindung werden im folgenden anhand der beiliegenden Zeichnung erläutert.

In dieser zeigen:

Fig. 1    eine schematische Darstellung der Funktionseinheiten einer erfindungsgemäßen Einrichtung zur Durchführung des erfindungsgemäßen Verfahrens und

Fig. 2    eine schematische Darstellung einer Realisierung der erfindungsgemäßen Einrichtung.

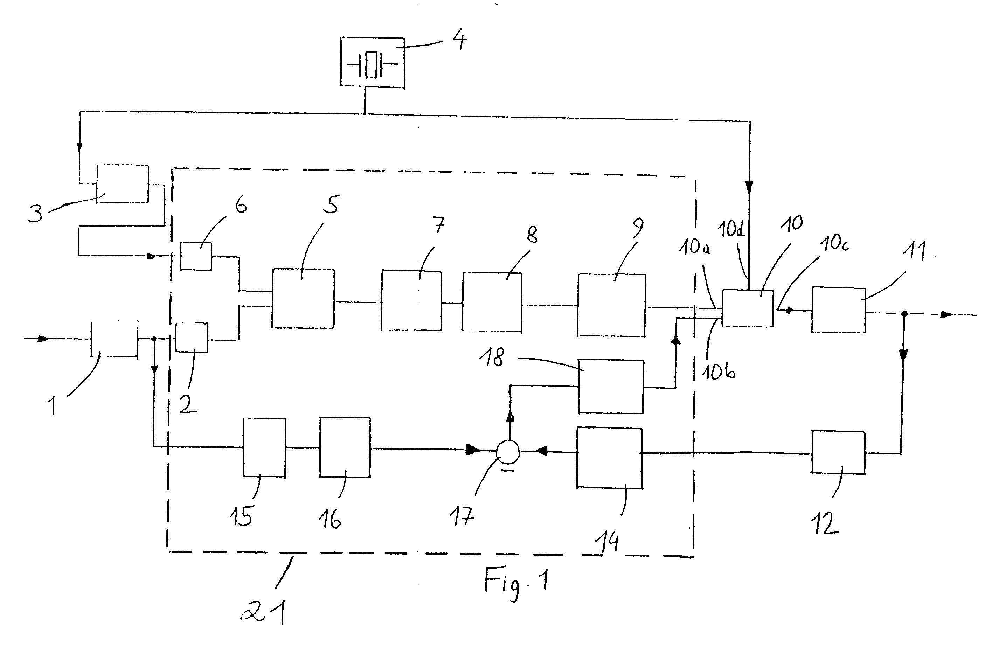

Unter Bezugnahme auf Fig. 1 wird folgendes erläutert:

Das Eingangssignal mit der Frequenz $f_E$ wird einem Eingangszähler 1 zugeführt, der die Anzahl der Perioden i des Eingangssignals zählt. Von der Einheit 2 wird der Eingangszähler 1 (vorzugsweise unmittelbar) nach jeder oder nach jeweils einer bestimmten Anzahl von Perioden ausgelesen und vom ausgelesenen Wert $i_n$ der beim vorhergehenden Auslesevorgang erhaltene Wert $i_{n-1}$ abgezogen. Es wird dadurch die Anzahl der Perioden $i_n-i_{n-1}$ des Eingangssignals zwischen den beiden Auslesevorgängen des Eingangszähler 1 erhalten.

Ein Taktgeber 4 erzeugt ein Rechtecksignal mit der Frequenz $f_s$, das als Systemtakt bezeichnet wird. Die Anzahl der Takte des Systemtakts werden von einem Systemtaktzähler 3 gezählt. Die Einheit 6 liest zu den selben Zeitpunkten, zu denen die Einheit 2 den Eingangszähler 1 ausliest, den Systemtaktzähler 3 aus und subtrahiert vom jeweils ausgelesenen Wert $s_n$ den beim vorhergigen Auslesen erhaltenen Wert $s_{n-1}$. Dadurch wird die Anzahl der Systemtakte $s_n-s_{n-1}$ zwischen zwei Auslesevorgängen erhalten.

Die Anzahl der Systemtakte zwischen zwei Auslesevorgängen sowie die Anzahl der Perioden des Eingangssignals zwischen zwei Auslesevorgängen werden der Einheit 5 zugeführt, welche die Eingangsfrequenz $f_E$ berechnet, indem sie das Verhältnis zwischen der Taktfrequenz $f_s$ des Systemtaktes und der Anzahl der Systemtakte zwischen zwei Auslesevorgängen bildet und das Ergebnis mit der Anzahl der Perioden des Eingangssignals zwischen zwei Auslesevorgängen multipliziert. Die Eingangsfrequenz $f_E$ ergibt sich also zu

$$f_E = (i_n - i_{n-1}) \frac{f_s}{S_n - S_{n-1}}.$$

Der Eingangszähler 1, der Systemtaktzähler 3 und die Einheiten 2, 5, 6 bilden somit zusammen eine Frequenzmeßeinrichtung zur Bestimmung der Eingangsfrequenz $f_E$ des Eingangssignals.

Die ermittelte Frequenz $f_E$ wird einer Filtereinheit 7 zugeführt, welche über eine Filterfunktion H(p) Schwankungen der Eingangsfrequenz ausgleicht. Man erhält die gefilterte Eingangsfrequenz $f'_E$.

Die Einheit 8 berechnet aus der gefilterten Eingangsfrequenz $f'_E$ die als digitales Signal vorliegende Ausgangsfrequenz $f_A$, indem sie mit dem Übersetzungsverhältnis Ü multipliziert,

$$f_A = Ü \cdot f'_E,$$

wobei

$$Ü = \frac{k_1}{k_2},$$

mit $k_1$ einer ersten Konstanten und $k_2$ einer zweiten Konstanten, die vorzugsweise ganze Zahlen sind.

Die berechnete Ausgangsfrequenz $f_A$ wird einem digitalen Signalgenerator 9, 10, 11 zugeführt, an dessen Ausgang das Ausgangssignal mit der Ausgangsfrequenz $f_A$ anliegt. Der Signalgenerator umfaßt ein Addierglied 10, welches einen Wert der an einem seiner Eingänge 10a, 10b anliegt, zu einem im Addierglied gespeicherten Wert addiert und diesen Wert am Ausgang 10c des Addiergliedes als Ausgabewert a ausgibt. Die Addition des am Eingang 10a anliegenden Wertes erfolgt, sobald ein Steuersignal an einem Steuereingang 10d angelegt wird. Dieses Steuersignal wird vom Taktgeber 4 abgenommen, sodaß das Addierglied 10 bei jedem vom Taktgeber 4 ausgegebenen Takt eine derartige Addition des am Eingang 10a anliegenden Wertes durchführt. Die Addition des am Eingang 10b anliegenden Wertes erfolgt, sobald ein Signal an einen weiteren, in Fig. 1 nicht gezeigten Steuereingang angelegt wird, beispielsweise nach jeder Periode des Eingangssignals (siehe weiter unten).

Der Ausgabewert des Addiergliedes 10 weist einen Maximalwert $a_{max}$ auf und bei einem Überschreiten dieses Maximalwertes um einen bestimmten Überlauf wird dieser Überlauf als neuer Ausgabewert gesetzt und ausgegeben (das Addierglied beginnt also bei einem Überschreiten des Maximalwertes wieder bei Null und addiert den Rest zu Null dazu). Das höchstwertige Bit des Ausgabewertes des Addiergliedes 10 wird von der Einheit 11 ausgefiltert und liegt am Ausgang der Einheit 11 als Ausgabesignal an, welches in diesem Ausführungsbeispiel somit ein Rechtecksignal ist. Die Periodendauer dieses Rechtecksignals wird durch die Zeitabstände zwischen dem jeweiligen Überschreiten des Maximalwertes des Addiergliedes 10 bestimmt.

In der Einheit 9 wird ein Inkrementalwert w berechnet, der an den Eingang 10a des Zählers 10 angelegt wird. Der Inkrementalwert w bestimmt sich aus dem Verhältnis zwischen der Ausgangsfrequenz $f_A$ und der Systemtaktfrequenz $f_s$ (bzw. der Frequenz, mit der der Inkrementalwert vom Eingang 10a zum Ausgabewert a addiert wird), multipliziert mit dem Maximalwert $a_{max}$ des Addiergliedes, also

$$W = a_{max} \frac{f_A}{f_s}.$$

Der Inkrementalwert w wird somit nach jedem Auslesevorgang durch die Einheiten 2 und 6 entsprechend der neuen Eingangsfrequenz $f_E$ und der daraus berechneten neuen Ausgangsfrequenz $f_A$ neu gesetzt. Das Addierglied addiert in der Folge diesen Inkrementalwert bei jedem Takt des Taktgebers 4 zu seinem Ausgabewert a. Solange der Ausgabewert a des Addiergliedes 10 kleiner als die Hälfte des Maximalwertes $a_{max}$ ist, liegt der Ausgang der Einheit 11 auf dem Massepotential, sobald der Ausgabewert des Addiergliedes die Hälfte des Maximalwertes überschreitet, liegt der Ausgang der Einheit 11 auf der Maximalspannung. Beim Einschalten der Einrichtung wird das Addierglied auf einen Ausgabewert a initialisiert, der um Eins unter Hälfte des Maximalwertes liegt, sodaß nach einer positiven Flanke des Eingangssignals möglichst ohne Phasenverzögerung eine positive Flanke des Ausgangssignals ausgegeben wird. Das digital erzeugte Ausgangssignal mit der Ausgangsfrequenz $f_A$ kann gegebenenfalls noch analog nachbearbeitet werden.

Ein Eingangssignal mit einer Eingangsfrequenz $f_E$ wird somit unmittelbar und digital in ein Ausgangssignal mit einer Ausgangsfrequenz $f_A$ übersetzt, die sich von der Eingangsfrequenz um das Übersetzungsverhältnis Ü unterscheidet, wodurch bei einer Änderung der Frequenz des Eingangssignals die Frequenz des Ausgangssignals dieser Änderung fast ohne Verzögerung folgt. Ohne weitere Maßnahmen würden aber die Phasenlage des Eingangssignals und die Phasenlage des Ausgangssignals sehr rasch auseinanderlaufen, wobei auch einzelne Impulse des Ausgangssignals verlorengehen könnten. Es wird daher eine Korrektur der Phasenlage des Ausgangssignals, beispielsweise nach jeweils einer Periode des Eingangssignals, durchgeführt. Es wäre aber je nach den speziellen Erfordernissen des konkreten Anwendungsfalles ebenfalls möglich, diese Phasenkorrektur nur nach jeweils mehreren Perioden des Eingangssignals oder auch mehrmals innerhalb einer Periode des Eingangssignals durchzuführen.

Um eine Korrektur der Phasenlage des Ausgangssignals durchzuführen, wird ein Phasenfehler des Ausgangssignals ermittelt. Dazu wird zunächst die Phase $\varphi_o$ des Ausgangssignals bestimmt. Zu diesem Zweck ist ein Ausgangszähler 12 vorgesehen, der die Anzahl o der Perioden des Ausgangssignals zählt. Diese Zahl o, welche ein Maß für die Phase $\varphi_o$ darstellt, wird einer Einheit 14 zugeführt und dort mit dem Faktor $k_2$ multipliziert.

Die Phase $\varphi_i$ des Eingangssignals entspricht direkt dem Zählwert i des Eingangszählers 1 und wird in der Filtereinheit 15 über eine Filterfunktion H(p) (vorzugsweise ein Tiefpaß) gefiltert. Weiters wird die gefilterte Phase $\varphi_i$ des Eingangssignals in der Einheit 16 mit dem Faktor $k_1$ multipliziert. Die mit $k_1$ multiplizierte Phase $\varphi_i$ des Eingangssignals wird nun im Subtrahierglied 17 von der mit $k_2$ multiplizierten Phase $\varphi_o$ des Ausgangssignals subtrahiert. Das Ergebnis dieser Subtraktion wird in der Einheit 18 durch den Faktor $k_2$ dividiert, womit man den Phasenfehler $\varphi_{err}$ des Ausgangssignals erhält. Es ist also

$$\varphi_{err} = \varphi_o - \varphi_i \cdot \frac{k_1}{k_2}.$$

Der Phasenfehler $\varphi_{err}$ des Ausgangssignals wird in der Einheit 18 weiters mit dem Maximalwert $a_{max}$ des Addiergliedes 10 multipliziert und anschließend dem Eingang 10b des Addiergliedes 10 zugeführt. Der am Eingang 10b anliegende Wert wird bei diesem Ausführungsbeispiel nach jeweils einer Periode des Eingangssignals neu gesetzt und vom Addierglied 10 zum Ausgabewert a des Addiergliedes 10 addiert, wodurch die Phase des Ausgangssignals korrigiert wird.

Anstelle der Ausgabe des Ausgabewertes a des Addiergliedes 10 an die Einheit 11 und der Filterung des höchstwertigen Bits könnte auch vorgesehen sein, daß das Addierglied bei jedem Überschreiten seines Maximalwertes einen Impuls an ein Flip-Flop ausgibt, wodurch ebenfalls ein Rechtecksignal erzeugt wird, welches allerdings nur die Hälfte der Frequenz des beschriebenen Ausführungsbeispiels aufweist.

Wird von der Einheit 11 nicht nur das höchstwertige Bit des Ausgabewertes verwendet, sondern mehrere oder alle Bits berücksichtigt, so kann von der Einheit 11 auch ein anderes Signal als ein Rechtecksignal ausgegeben werden, beispielsweise ein Sinussignal. Dazu könnte beispielsweise eine ROM-Tabelle vorgesehen sein, die einem jeweiligen Ausgabewert a des Addiergliedes 10 eine bestimmte von der Einheit 11 auszugebende Spannung zuordnet.

Durch die erfindungsgemäße Einrichtung kann die Phasenabweichung zwischen dem Eingangssignal und dem Ausgangssignal äußerst gering gehalten werden, wobei eine exakte Nachführung der Phasenlage auch bei großen Schwankungen der Eingangsfrequenz erfolgt. Die Einrichtung weist eine hohe Dynamik auf. Auch bei einer sehr schnellen Änderung der Frequenz des Eingangssignals ändert sich die Frequenz des Ausgangssignals sofort auf den gewünschten Wert (Größenordnung 20 Mikrosekunden). Die Einrichtung funktioniert weiters über einen sehr großen Bereich der Eingangsfrequenz, der sich von nahe Null bis in den Megahertzbereich erstreckt.

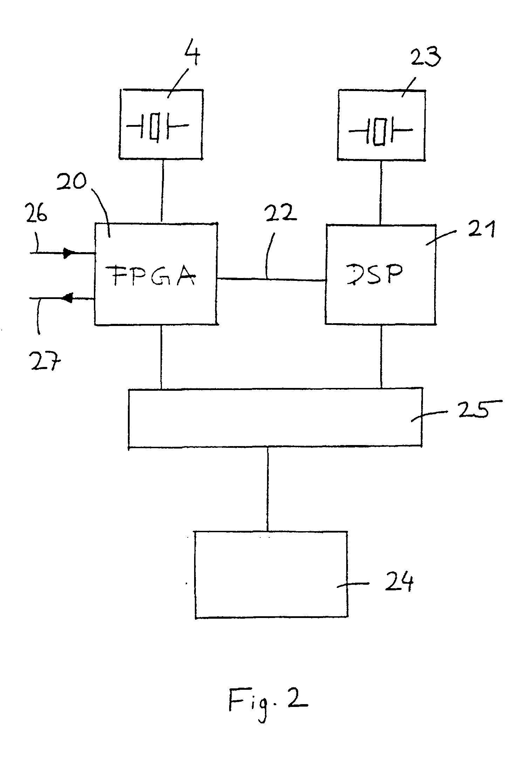

Eine Realisierung der erfindungsgemäßen Einrichtung ist in der Fig. 2 dargestellt. Diese Realisierung weist als Kernstücke eine programmierbare Logikeinheit 20 und einen digitalen Signalprozessor (DSP) 21 auf. Die programmierbare Logikeinheit 20, kurz FPGA ("field programmable gate array"), kann für unterschiedliche logische Operationen programmiert werden und in dieser sind der Eingangszähler 1, der Systemtaktzähler 3, das Addierglied 10, die Einheit 11 und der Ausgangszähler 12 realisiert. Das Eingangssignal wird dem Eingang 26 der FPGA zugeführt und das Ausgangssignal am Ausgang 27 der FGPA abgenommen. Als FPGA-Baustein kann der XC4013XL-3 BG256C der Firma XILINX, Inc. verwendet werden.

Die FPGA 20 ist über einen digitalen Datenbus 22 mit dem digitalen Signalprozessor verbunden, durch den die Einheiten 2, 5, 6 bis 9 und 14 bis 18 der Fig. 1 realisiert sind. Als DSP 21 kann die Type ADSP-21062L KB-160 der Firma Analog Devices, Inc. verwendet werden.

Der Systemtakt mit der Frequenz $f_s$ wird der FPGA vom Taktgeber 4 zur Verfügung gestellt. Ein weiterer Taktgeber 23 erzeugt einen zweiten Systemtakt, der sich vom Systemtakt des Taktgebers 4 im allgemeinen unterscheiden wird und stellt diesen der DSP 21 zur Verfügung.

Die Programmierung der verschiedenen logischen Funktionen der FPGA und die Bereitstellung der Programmabläufe für den digitalen Signalprozessor erfolgt über einen Prozeßrechner 24, der mit der FPGA und dem digitalen Signalprozessor über Datenbusse und eine Schnittstelle 25 verbunden ist.

Anstelle des Prozeßrechners 24 und der Schnittstelle 25 könnten die Programmierung der FPGA und die Programmabläufe des digitalen Signalprozessors auch in EPROMS gespeichert sein.

Auch ein diskreter Aufbau der verschiedenen in Fig. 1 beschriebenen Einheiten wäre prinzipiell denkbar und möglich.

**Patentansprüche**

1. Verfahren zum Erzeugen eines Ausgangssignals, dessen Ausgangsfrequenz sich um ein vorgebbares Übersetzungsverhältnis von der veränderbaren Eingangsfrequenz eines Eingangssignals unterscheidet, wobei die Phase des Ausgangssignals mit der Phase des Eingangssignals gekoppelt ist, und wobei die Eingangsfrequenz ($f_E$) des Eingangssignals bezogen auf den Systemtakt eines Taktgebers (4) ermittelt wird, ein der Ausgangsfrequenz ($f_A$) entsprechender Wert als digitales Signal über das vorgegebene Übersetzungsverhältnis (Ü) aus der Eingangsfrequenz berechnet wird, ein Ausgangssignal mit dieser Ausgangsfrequenz ($f_A$) von einem digitalen Signalgenerator (9, 10, 11) erzeugt wird, die Phase ($\varphi_o$) des Ausgangssignals entsprechend dem Zählwert (o) eines Ausgangszählers (12) ermittelt wird, die Phase ($\varphi_i$) des Eingangssignals entsprechend dem Zählwert (i) eines Eingangszählers (1) ermittelt wird, ein Phasenfehler ($\varphi_{err}$) der Phase ($\varphi_0$) des Ausgangssignals bezüglich der Phase ($\varphi_i$) des Eingangssignals bestimmt wird und zu vorgegebenen Zeitpunkten eine Korrektur der Phase ($\varphi_o$) des Ausgangssignals durchgeführt wird.

2. Verfahren nach Anspruch 1, **dadurch gekennzeichnet, daß** das Ausgangssignal über einen Signalgenerator (9, 10, 11) erzeugt wird, der ein Addierglied (10) umfaßt, dessen Ausgabewert (a) einen Maximalwert ($a_{max}$) aufweist und das bei einem Überschreiten dieses Maximalwertes um einen Überlauf diesen Überlauf als neuen Ausgabewert (a) setzt, wobei zum Ausgabewert (a) in vorgegebenen Zeitabständen ein Inkrementalwert (w) addiert wird.

3. Verfahren nach Anspruch 2, **dadurch gekennzeichnet, daß** die vorgegebenen Zeitabstände, zu denen das Addierglied (10) des Signalgenerators den Inkrementalwert (w) zum Ausgabewert (a) addiert, durch den von dem Taktgeber (4) erzeugten Systemtakt ($f_s$) bestimmt sind.

4. Verfahren nach Anspruch 2 oder Anspruch 3, **dadurch gekennzeichnet, daß** der Inkrementalwert (w) durch Bildung des Verhältnisses zwischen der Frequenz ($f_A$) des Ausgangssignals und der Frequenz ($f_s$) der Inkrementierung des Ausgangswertes des Addiergliedes (10) sowie Multiplikation dieses Verhältnisses mit dem Maximalwert ($a_{max}$) des Addiergliedes bestimmt wird.

5. Verfahren nach einem der Ansprüche 2 bis 4, **dadurch gekennzeichnet, daß** zur Erzeugung eines Rechteck-Ausgangssignals das Ausgangssignal vom höchstwertigen Bit des Addiergliedes (10) abgeleitet wird.

6. Verfahren nach einem der Ansprüche 2 bis 5, **dadurch gekennzeichnet, daß** zur Korrektur der Phase ($\varphi_o$) des Ausgangssignals vom Addierglied (10) ein positiver oder negativer Korrekturwert zum Ausgangswert (a) addiert wird.

7. Verfahren nach Anspruch 6, **dadurch gekennzeichnet, daß** der Korrekturwert dem Phasenfehler ($\varphi_{err}$) des Ausgangssignals multipliziert mit dem Maximalwert ($a_{max}$) des Addiergliedes (10) entspricht.

8. Verfahren nach einem der Ansprüche 2 bis 7, **dadurch gekennzeichnet, daß** zur Bestimmung des Phasenfehlers ($\varphi_{err}$) des Ausgangssignals bezüglich des Eingangssignals die Phase ($\varphi_o$) des Ausgangssignals bestimmt wird.

9. Verfahren nach einem der Ansprüche 1 bis 8, wobei das Übersetzungsverhältnis (Ü) durch eine erste Konstante ($k_1$) geteilt durch eine zweite Konstante ($k_2$) gebildet wird, **dadurch gekennzeichnet, daß** zur Bestimmung des Phasenfehlers ($\varphi_{err}$) des Ausgangssignals die Phase ($\varphi_i$) des Eingangssignals mit der ersten Konstanten ($k_1$) multipliziert wird, von der mit der zweiten Konstanten ($k_2$) multiplizierten Phase ($\varphi_o$) des Ausgangssignals subtrahiert wird und das Ergebnis dieser Subtraktion durch die zweite Konstante ($k_2$) geteilt wird.

10. Verfahren nach einem der Ansprüche 1 bis 9, **dadurch gekennzeichnet, daß** eine Korrektur der Phase ($\varphi_o$) des Ausgangssignals jeweils nach einer Periode oder nach einer bestimmten Anzahl von Perioden des Eingangssignals, vorzugsweise bei dessen positivem oder negativem Nulldurchgang durchgeführt wird.

11. Verfahren nach einem der Ansprüche 1 bis 10, **dadurch gekennzeichnet, daß** zur Bestimmung der Frequenz ($f_E$) des Eingangssignals das Verhältnis zwischen der Frequenz ($f_s$) des von dem Taktgeber vorgegebenen Systemtakts und der Anzahl ($s_n - s_{n-1}$) der von einem Systemtaktzähler (3) gezählten Takte gebildet wird, wobei die Takte über eine oder mehrere Perioden des Eingangssignals gezählt werden, und das Ergebnis des genannten Verhältnisses im Falle des Zählens der Takte über mehrere Perioden $i_n - i_{n-1}$ mit der Anzahl der Perioden multipliziert wird.

12. Verfahren nach einem der Ansprüche 1 bis 11, **dadurch gekennzeichnet, daß** die Eingangsfrequenz von einer Filtereinrichtung (7) - vorzugsweise mit Tiefpaß-Charakteristik - gefiltert wird.

13. Einrichtung zum Erzeugen eines Ausgangssignals, dessen Ausgangsfrequenz sich um ein vorgebbares Übersetzungsverhältnis von der veränderbaren Eingangsfrequenz eines Eingangssignals unterscheidet, wobei die Phase des Ausgangssignals mit der Phase des Eingangssignals gekoppelt ist, und wobei eine Frequenzmeßeinrichtung (1, 2, 3, 5, 6), an der das Eingangssignal anliegt, zur Messung der Eingangsfrequenz ($f_E$) bezogen auf den Systemtakt eines Taktgebers (4), eine Einrichtung (8) zur Berechnung der Ausgangsfrequenz ($f_A$) aus der von der Frequenzmeßeinrichtung (1, 2, 3, 5, 6) gemessenen Eingangsfrequenz ($f_E$), ein digitaler Signalgenerator (9, 10, 11), an dessen Eingang die berechnete Ausgangsfrequenz ($f_A$) als digitales Signal anliegt, zur Erzeugung des Ausgangssignals mit der berechneten Ausgangsfrequenz ($f_A$), eine Phasenmeßeinrichtung (12) zur Messung der Phase ($\varphi_o$) des Ausgangssignals entsprechend dem Zählwert eines Ausgangszählers (12) und eine Phasenkorrektureinrichtung (14, 16, 17, 18) zur Bestimmung des Phasenfehlers ($\varphi_{err}$) der Phase des Ausgangssignals bezüglich der Phase des Eingangssignals, bestimmt durch den Zählwert eines Eingangszählers (1) und zur Korrektur der Phase ($\varphi_o$) des Ausgangssignals zu vorgegebenen Zeitpunkten vorgesehen sind.

**14.** Einrichtung nach Anspruch 13, **dadurch gekennzeichnet, daß** der digitale Signalgenerator (9, 10, 11) für die Erzeugung des Ausgangssignals ein Addierglied (10) aufweist, welches einen oder mehrere Eingänge (10a, 10b) zum Anlegen von zu einem Ausgabewert (a), der an einem Ausgang (10c) anliegt, zu addierenden Werten aufweist.

**15.** Einrichtung nach Anspruch 13 oder Anspruch 14, **dadurch gekennzeichnet, daß** ein Taktgeber (4) zur Vorgabe eines Systemtaktes vorgesehen ist.

**16.** Einrichtung nach Anspruch 15, **dadurch gekennzeichnet, daß** zur Bestimmung der Eingangsfrequenz ($f_E$) ein die Takte des Systemttaktes zählender Systemtaktzähler (3) vorgesehen ist.

**17.** Einrichtung nach einem der Ansprüche 13 bis 16, **dadurch gekennzeichnet, daß** der Eingangszähler (1) zum Zählen der Perioden des Eingangssignals vorgesehen ist.

**18.** Einrichtung nach einem der Ansprüche 13 bis 17, **dadurch gekennzeichnet, daß** der Ausgangszähler (12) zum Zählen der Perioden des Ausgangssignals vorgesehen ist.

**19.** Einrichtung nach einem der Ansprüche 13 bis 18, **dadurch gekennzeichnet, daß** zur Berechnung der Ausgangsfrequenz aus der Eingangsfrequenz ein digitaler Signalprozessor (21) vorgesehen ist.

**20.** Einrichtung nach Anspruch 19, **dadurch gekennzeichnet, daß** der digitale Signalprozessor (21), vorzugsweise über einen Datenbus, mit einer programmierbaren Logikeinheit (20) verbunden ist.

## Claims

**1.** A process for producing an output signal whose output frequency differs from the alterable input frequency of an input signal by a predetermined transformation ratio, wherein the phase of the output signal is coupled to the phase of the input signal and wherein the input frequency ($f_E$) of the input signal is ascertained relating to a system clock of a clock (4), the output frequency ($f_A$) is calculated from the input frequency as a digital signal by way of the predetermined transformation ratio ($Ü$), an output signal is produced with that output frequency ($f_A$) by a digital signal generator (9, 10, 11), the phase ($\varphi_o$) of the output signal is ascertained corresponding to the count value (o) of an output counter 12, the phase ($\varphi_i$) of the input signal is ascertained corresponding to the count value (i) of an input counter (1), a phase error ($\varphi_{err}$) of the phase ($\varphi_o$) of the output signal relating to the phase ($\varphi_i$) of the input signal is determined and correction of the phase ($\varphi_o$) of the output signal is effected at predetermined times.

**2.** A process according to claim 1 **characterised in that** the output signal is produced by way of a signal generator (9, 10, 11) which includes an adding member (10) whose output value (a) has a maximum value ($a_{max}$) and which when that maximum value is exceeded by an excess sets that excess as a new output value (a), wherein an incremental value (w) is added to the output value (a) at predetermined intervals.

**3.** A process according to claim 2 **characterised in that** the predetermined intervals at which the adding member (10) of the signal generator adds the incremental value (w) to the output value (a) is determined by the system dock ($f_s$) produced by a clock (4).

**4.** A process according to claim 2 or claim 3 **characterised in that** the incremental value (w) is determined by forming the ratio between the frequency ($f_A$) of the output signal and the frequency ($f_s$) of incrementing of the output value of the adding member (10) and multiplication of that ratio by the maximum value ($a_{max}$) of the adding member.

**5.** A process according to one of claims 2 through 4 **characterised in that** to produce a rectangular output signal the output signal is derived from the most significant bit of the adding member (10).

**6.** A process according to one of claims 2 through 5 **characterised in that** for correction of the phase ($\varphi_o$) of the output signal from the adding member (10) a positive or negative correction value is added to the output value (a).

**7.** A process according to in claim 6 **characterised in that** the correction value corresponds to the phase

error ($\varphi_{err}$) of the output signal multiplied by the maximum value ($a_{max}$) of the adding member (10).

8.  A process according to one of claims 2 through 7 **characterised in that** for determining the phase error ($\varphi_{err}$) of the output signal relating to the input signal the phase ($\varphi_o$) of the output signal is determined.

9.  A process according to one of claims 1 through 8 wherein the transformation ratio (Ü) is formed by a first constant ($k_1$) divided by a second constant ($k_2$) **characterised in that** for determining the phase error ($\varphi_{err}$) of the output signal the phase ($\varphi_i$) of the input signal is multiplied by the first constant ($k_1$), and subtracted from the phase ($\varphi_o$) of the output signal which is multiplied by the second constant ($k_2$) and the result of that subtraction operation is divided by the second constant ($k_2$).

10. A process according to one of claims 1 through 9 **characterised in that** a correction of the phase ($\varphi_o$) of the output signal is respectively effected after a period or after a given number of periods of the input signal, preferably at the positive or negative passage-through-zero thereof.

11. A process according to one of claims 1 through 10 **characterised in that** for determining the frequency ($f_E$) of the input signal the ratio between the frequency ($f_s$) of the system clock which is predetermined by a clock and the number ($s_n$-$s_{n-1}$) of the clocks counted by a system clock counter (3) is formed, wherein the clocks are counted over one or more periods of the input signal, and the result of said ratio in the case of counting the clocks over a plurality of periods $i_n$-$i_{n-1}$ is multiplied by the number of periods.

12. A process according to one of claims 1 through 11 **characterised in that** the input frequency is filtered by a filter device (7), preferably with a low pass characteristic.

13. Apparatus for producing an output signal whose output frequency differs from the alterable input frequency of an input signal by a predetermined transformation ratio, wherein the phase of the output signal is coupled to the phase of the input signal and wherein there are provided a frequency measuring device (1, 2, 3, 5, 6) to which the input signal is applied, for measuring the input frequency ($f_E$) relating to a system clock of a clock (4), a device (8) for calculating the output frequency ($f_A$) from the input frequency ($f_E$) measured by the frequency measuring device (1, 2, 3, 5, 6), a digital signal generator (9, 10, 11) to the input of which the calculated output frequency ($f_A$) is applied as a digital signal, to produce the output signal at the calculated output frequency ($f_A$), a phase measuring device (12) for measuring the phase ($\varphi_o$) of the output signal corresponding to the count value of an output counter (12), and a phase correction device (14, 16, 17, 18) for determining the phase error (($\varphi_{err}$) of the phase of the output signal relating to the phase of the input signal determined by the count value (i) of an input counter (1) and for correcting the phase ($\varphi_o$) of the output signal at predetermined times.

14. Apparatus according to claim 13 **characterised in that** the digital signal generator (9, 10, 11) for producing the output signal has an adding member (10) having one or more inputs (10a, 10b) for applying values to be added to an output value (a) which occurs at an output (10c).

15. Apparatus according to claim 13 or claim 14 **characterised in that** there is provided a clock (4) for presetting a system clock.

16. Apparatus according to claim 15 **characterised in that** for determining the input frequency ($f_E$) there is provided a system clock counter (3) for counting the clocks of the system clock.

17. Apparatus according to one of claims 13 through 16 **characterised in that** there is provided the input counter (1) for counting the periods of the input signal.

18. Apparatus according to one of claims 13 through 17 **characterised in that** there is provided the output counter (12) for counting the periods of the output signal.

19. Apparatus according to one of claims 13 through 18 **characterised in that** there is provided a digital signal processor (21) for calculating the output frequency from the input frequency.

20. Apparatus according to claim 19 **characterised in that** the digital signal processor (21) is connected to a programmable logic unit (20), preferably by way of a data bus.

**Revendications**

1.  Procédé pour produire un signal de sortie dont la fréquence de sortie, par un rapport qui peut être fixé d'avance, se différencie de la fréquence d'alimentation modifiable d'un signal d'entrée, selon lequel la phase du signal de sortie est connectée à la phase du signal d'entrée, et la fréquence d'alimentation ($f_E$) du signal d'entrée, rapportée à la cadence système d'une horloge interne (4) est déterminée, une valeur correspondant à la fréquence de sortie ($f_A$)

est calculée sous la forme d'un signal numérique à partir de la fréquence d'alimentation par le rapport (Ü) fixé d'avance, un signal de sortie avec cette fréquence de sortie ($f_A$) est produit par un générateur numérique de signaux (9, 10, 11) numérique, la phase ($\varphi_o$) du signal de sortie est déterminée conformément à la valeur de comptage (o) d'un compteur de sortie (12), la phase ($\varphi_I$) du signal d'entrée est déterminée conformément à la valeur de comptage (i) d'un compteur d'entrée (1), une erreur de phase ($\varphi_{ERR}$) de la phase ($\varphi_o$) du signal de sortie relativement à la phase ($\varphi_I$) du signal d'entrée est déterminée et une correction de la phase ($\varphi_o$) du signal de sortie est effectuée à des moments fixés d'avance.

**2.** Procédé selon la revendication 1, **caractérisé en ce que** le signal de sortie est produit par un générateur de signaux (9, 10, 11), qui comprend un élément additionneur (10) dont la valeur de sortie (a) présente une valeur maximale ($a_{MAX}$) et qui, lorsque cette valeur maximale est dépassée, instaure la valeur de ce dépassement comme nouvelle valeur de sortie (a), une valeur incrémentielle (w) étant additionnée à la valeur de sortie (a) à des intervalles de temps fixés d'avance.

**3.** Procédé selon la revendication 2, **caractérisé en ce que** les intervalles de temps fixés d'avance auxquels l'élément additionneur (10) du générateur de signaux additionne la valeur incrémentielle (w) à la valeur de sortie (a), sont déterminés par la cadence système ($f_s$) produite par l'horloge interne (4).

**4.** Procédé selon la revendication 2 ou la revendication 3, **caractérisé en ce que** la valeur incrémentielle (w) est déterminée par la formation du rapport entre la fréquence ($f_A$) du signal de sortie et la fréquence ($f_s$) de l'incrémentation de la valeur de sortie de l'élément additionneur (10) ainsi que par la multiplication de ce rapport par la valeur maximale ($a_{MAX}$) de l'élément additionneur.

**5.** Procédé selon l'une des revendications 2 à 4, **caractérisé en ce que** pour la production d'un signal de sortie rectangulaire, le signal de sortie est déduit du bit de l'élément additionneur (10) dont la valeur est la plus élevée.

**6.** Procédé selon l'une des revendications 2 à 5, **caractérisé en ce que** pour la correction de la phase ($\varphi_o$) du signal de sortie de l'élément additionneur (10), une valeur de correction positive ou négative est additionnée à la valeur de sortie (a).

**7.** Procédé selon la revendication 6, **caractérisé en ce que** la valeur de correction correspond à l'erreur de phase ($\varphi_{ERR}$) du signal de sortie, multipliée par

la valeur maximale ($a_{max}$) de l'élément additionneur (10).

**8.** Procédé selon l'une des revendications 2 à 7, **caractérisé en ce que**, pour la détermination de l'erreur de phase ($\varphi_{err}$) du signal de sortie, la phase ($\varphi_o$) du signal de sortie est déterminée relativement au signal d'entrée.

**9.** Procédé selon l'une des revendications 1 à 8, selon lequel le rapport (Ü) est formé par une première constante ($k_1$), divisée par une deuxième constante ($k_2$), **caractérisé en ce que** pour la détermination de l'erreur de phase ($\varphi_{err}$) du signal de sortie, la phase ($\varphi_1$) du signal d'entrée est multipliée par la première constante ($k_1$), et soustraite de la phase ($\varphi_o$) du signal de sortie multipliée par la deuxième constante ($k_2$), et le résultat de cette soustraction est divisé par la deuxième constante ($k_2$).

**10.** Procédé selon l'une des revendications 1 à 9, **caractérisé en ce qu'**une correction de la phase ($\varphi_o$) du signal de sortie est effectuée chaque fois après une période ou après un nombre déterminé de périodes du signal d'entrée, de préférence lorsque celui-ci passe par zéro positif ou négatif.

**11.** Procédé selon l'une des revendications 1 à 10, **caractérisé en ce que** pour la détermination de la fréquence ($f_E$) du signal d'entrée, on forme le rapport entre la fréquence ($f_s$) de la cadence système, fixée d'avance par l'horloge interne, et le nombre ($s_n$-$s_{n-1}$) des cadences dénombrées par un compteur de cadences système (3), les cadences étant dénombrées sur une ou plusieurs périodes du signal d'entrée, et le résultat du rapport cité est multiplié en cas de dénombrement des cadences sur plusieurs périodes ($i_n$-$i_{n-1}$), par le nombre de ces périodes.

**12.** Procédé selon l'une des revendications 1 à 11, **caractérisé en ce que** la fréquence d'alimentation est filtrée par un mécanisme de filtrage (7) - de préférence avec des propriétés de filtre passe-bas.

**13.** Mécanisme pour la production d'un signal de sortie, dont la fréquence de sortie se différencie de la fréquence d'alimentation modifiable d'un signal d'entrée, par un rapport qui peut être fixé d'avance, dans lequel la phase du signal de sortie est connectée à la phase du signal d'entrée, et dans lequel il est prévu un mécanisme de mesure de la fréquence (1, 2, 3, 5, 6) auquel est appliqué le signal d'entrée, pour mesurer la fréquence d'alimentation ($f_E$), sur la base de la cadence système ($f_s$) d'une horloge interne (4), un mécanisme (8) pour calculer la fréquence de sortie ($f_A$) à partir de la fréquence d'alimentation ($f_E$) mesurée par le mécanisme de mesure de la fréquence (1, 2, 3, 5, 6), un générateur numérique de signaux (9, 10, 11), à l'entrée duquel la fréquence calculée de sortie ($f_A$) est appliquée comme signal numérique, pour produire le signal de sortie avec la fréquence de sortie ($f_A$) calculée, un mécanisme de mesure de phases (12) pour mesurer la phase ($\varphi_o$) du signal de sortie, conformément à la valeur de comptage d'un compteur de sortie (12), et un mécanisme de correction de phase (14, 16, 17, 18) pour déterminer l'erreur de phase ($\varphi_{err}$) de la phase du signal de sortie, relativement à la phase du signal d'entrée, déterminée par la valeur de comptage d'un compteur d'entrée (1), et pour corriger la phase ($\varphi_o$) du signal de sortie à des moments fixés à l'avance.

**14.** Mécanisme selon la revendication 13, **caractérisé en ce que** le générateur numérique de signaux (9, 10, 11) présente pour la production du signal de sortie un élément additionneur (10) qui présente une ou plusieurs entrées (10a, 10b) pour appliquer des valeurs à additionner à une valeur de sortie (a) qui est appliquée à une sortie (10c).

**15.** Mécanisme selon la revendication 13 ou la revendication 14, **caractérisé en ce qu'**une horloge interne (4) est prévue pour prédéfinir une cadence système.

**16.** Mécanisme selon la revendication 15, **caractérisé en ce que** pour la détermination de la fréquence d'alimentation ($f_E$) un compteur de cadences système (3) est prévu qui dénombre les cadences de la cadence système.

**17.** Mécanisme selon l'une des revendications 13 à 16, **caractérisé en ce que** le compteur d'entrée (1) est prévu pour dénombrer les périodes du signal d'entrée.

**18.** Mécanisme selon l'une des revendications 13 à 17, **caractérisé en ce que** le compteur de sortie (12) est prévu pour le dénombrement des périodes du signal de sortie.

**19.** Mécanisme selon l'une des revendications 13 à 18, **caractérisé en ce que** pour le calcul de la fréquence de sortie à partir de la fréquence d'alimentation, est prévu un processeur numérique de signaux (21).

**20.** Mécanisme selon la revendication 19, **caractérisé en ce que** le processeur numérique de signaux (21) est connecté à une unité logique (20) programmable, de préférence par l'intermédiaire d'un bus de données.

Fig. 1

Fig. 2